## Europäisches Patentamt

## European Patent Office

## Office européen des brevets

(19)

(11) Veröffentlichungsnummer: **0 070 510**
**B1**

(12) # EUROPÄISCHE PATENTSCHRIFT

(45) Veröffentlichungstag der Patentschrift:
**23.10.85**

(51) Int. Cl.⁴: **G 03 F 7/10,** G 03 F 7/02

(21) Anmeldenummer: **82106294.0**

(22) Anmeldetag: **14.07.82**

(54) **Verfahren zur Herstellung von Fotopolymer-Tiefdruckformen.**

(30) Priorität: **22.07.81 DE 3128951**

(43) Veröffentlichungstag der Anmeldung:
**26.01.83 Patentblatt 83/4**

(45) Bekanntmachung des Hinweises auf die Patenterteilung:
**23.10.85 Patentblatt 85/43**

(84) Benannte Vertragsstaaten:
**BE DE FR GB IT NL SE**

(56) Entgegenhaltungen:
**AT - B - 293 449**
**DE - A - 2 939 785**
**GB - A - 1 154 749**

(73) Patentinhaber: **BASF Aktiengesellschaft,
Carl-Bosch-Strasse 38, D-6700 Ludwigshafen (DE)**

(72) Erfinder: **Lynch, John, Dr., Bachusstrasse 15,
D-6521 Monsheim (DE)**
Erfinder: **Elzer, Albert, Dr., Pappelstrasse 4,
D-6701 Otterstadt (DE)**
Erfinder: **Schoeffel, Gerhard, Stettiner Strasse 1,
D-6703 Limburgerhof (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Herstellung von Tiefdruckformen durch Nachbehandlung von Fotopolymer-Relieformen zur Erzielung einer harten, abrieb- und kratzfesten Druckform.

Während heute im Hochdruck aufgrund ihrer leichteren Herstellung im großen Umfang Fotopolymer-Reliefdruckformen Eingang gefunden haben, arbeitet man beim Tiefdruck immer noch mit Metalldruckformen, die im allgemeinen an der Oberfläche eine verchromte Kupferschicht aufweisen, in der sich die für die Farbaufnahme erforderlichen Näpfchen befinden. Die hohen Kosten der Herstellung solcher Metalltiefdruckformen hat den Tiefdruck auf Anwendungsgebiete beschränkt, wo neben hoher Druckqualität eine große Auflagenhöhe gefordert ist.

Aus der DE-A-27 52 500 ist bekannt, Tiefdruckformen aus Kunststoff herzustellen, wobei die Näpfchen mechanisch eingraviert werden.

Zur Vermeidung von Schrammen und Riefen an der Oberfläche der Tiefdruckform werden hierbei anstelle üblicher Stahlrakeln spezielle Kunststoffrakeln beim Druck verwandt. Doch weder die umständliche Herstellung solcher Tiefdruckformen noch die damit erzielbare Auflagenhöhe beim Druck ist befriedigend.

Die Herstellung von Tiefdruckformen durch bildmäßiges Belichten von Fotoinitiator enthaltenden fotopolymerisierbaren Mischungen, wie sie für die Herstellung von Hochdruckformen verwendet werden, ist z. B. in den DE-A-20 54 833 und DE-A-20 61 287 der Anmelderin sowie der jap. Patentschrift 41 361/72 beschrieben. Solche Tiefdruckformen sind jedoch bezüglich der Kratzfestigkeit ihrer Oberflächen und der damit erzielbaren Auflagenhöhe noch nicht befriedigend.

Der Erfindung lag die Aufgabe zugrunde, auf der Basis in ihrer Art bekannter Fotoinitiator enthaltender Mischung von Polymerbindemitteln und fotopolymerisierbaren Monomeren durch bildmäßiges Belichten von Schichten mit solchen Mischungen und anschließendes Entfernen der unbelichteten Schichtanteile Tiefdruckformen auf einfache Weise herzustellen, die eine verbesserte Abriebfestigkeit und Kratzfestigkeit aufweisen.

Es wurde überraschend gefunden, daß sich so verbesserte Fotopolymer-Tiefdruckformen einfach herstellen lassen durch

a) bildmäßiges Belichten mit aktinischem Licht von einer auf einem dimensionsstabilen Träger aufgebrachten, etwa 30 bis 600 µm starken Schicht S mit einer einen Fotoinitiator enthaltenden Mischung M von

M1) mindestens einem in einem wäßrigen oder alkoholischen Lösungsmittel löslichen oder dispergierbaren Polymerbindemittel und
M2) mindestens einem damit verträglichen fotopolymerisierbaren olefinisch ungesättigten Monomeren,

b) Entfernen der unbelichteten Schichtanteile,
c) ggf. Nachbelichten sowie
d) Trocknen der resultierenden Reliefform, ggf. unter Integration des Nachbelichtens,

wenn man die entwickelte und ggf. nachbelichtete Reliefform bei 60 bis 130°C, insbesondere bei 80 bis 120°C trocknet und danach zur Erzielung einer harten, nichtspröden Tiefdruckform die Reliefschicht S durch Einbrennen bei 200 bis 260°C, insbesondere 220 bis 240°C, um 10 bis 50 und insbesondere 15 bis 30% der Schichtdicke, bezogen auf die Schichtdicke vor dem Einbrennen, schrumpft.

Gegenstand der Erfindung ist somit ein Verfahren zur Herstellung von Tiefdruckformen durch Nachbehandlung von Reliefformen sowie die Verwendung von so nachbehandelten Reliefformen für den Tiefdruck. Unter Tiefdruckformen werden hierbei Druckplatten, Druckfolien oder Druckzylinder mit Reliefformen verstanden, die die farbführenden Bildteile für den Druck als Vertiefungen in der Oberfläche aufweisen. Die Vertiefungen sind hierbei in der fotopolymeren Schicht S, die im allgemeinen haftfest auf einen dimensionsstabilen Träger, wie eine Metallplatte oder einen Metallzylinder aufgebracht ist. Die Stärke der Schicht S beträgt dabei im allgemeinen nach dem Einbrennen der Schicht 30 bis 300 und insbesondere 50 bis 200 µm. Die Tiefe der Näpfchen (die die Druckfarbe aufnehmen) beträgt im allgemeinen wenige µm, z. B. 2 bis 3 µm für die Näpfchen mit kleiner Tiefe und 10 bis 100 µm, insbesondere 20 bis 60 µm, für die Näpfchen großer Tiefe.

Als Polymerbindemittel für die Mischung M der Schicht S — im allgemeinen das Basismaterial der Schicht S — sind in wäßrigen oder alkoholischen Lösungsmitteln lösliche oder dispergierbare synthetische Polymere geeignet, wie sie für die Herstellung von Fotopolymer-Reliefformen bekannt sind, soweit sie in der Mischung beim Einbrennen bei 200 bis 260°C unter Schrumpfen einen deutlichen Anstieg der Oberflächenhärte der Schicht zeigen. Die Auswahl der Materialien M1 und M2 für die Schicht S ist für den Fachmann anhand einiger Versuche unschwierig möglich. Bevorzugt sind Materialien für die Schicht S, die nach dem Belichten, ggf. Nachbelichten, Vortrocknen und Einbrennen eine Schicht S ergeben, die mindestens an der Oberfläche eine unter Last gemessene Vickers-Härte von mindestens 50 und bevorzugt von mindestens 100 N/mm² aufweist.

Als vorteilhafte Polymerbindemittel für die Mischung M haben sich insbesondere Vinylalkohol-Polymere mit -CH₂CH(OH)-Struktureinheiten in der Polymerhauptkette erwiesen sowie deren in Wasser oder wäßrigen Lösungsmitteln lösliche oder dispergierbare Copolymerisate und Derivate, wie Ester, Ether oder Acetale. Besonders geeignet sind die bekannten verseiften Polyvinylester von aliphatischen Monocarbonsäuren mit 1 bis 4 C-Atomen, wie Polyvinylacetate oder Polyvinylpropionate, deren mittlerer Polymerisationsgrad 200 bis 3000 und insbesondere 250 bis 750, und deren Verseifungsgrad 65 bis etwa 100 und insbesondere 80 bis 88 Mol.% beträgt. Auch Gemische von verseiften Vinylester-Polymeren oder -Copolymeren mit unterschiedlichem Polymerisationsgrad und/oder unterschiedlichem Verseifungsgrad können angewandt werden. Ferner seien in diesem Zusammenhang die Umsetzungsprodukte von Vinylalkohol-Polymeren mit Acryl- und/oder Methacrylsäureanhydrid erwähnt, wobei diese Umsetzungsprodukte im allgemeinen 3 bis 30 Gew.-%, bezogen auf das Umsetzungsprodukt, an Acryloyl- oder Methacryloyl-Gruppen eingebaut enthalten, als auch die wasserlöslichen Umsetzungsprodukte von Vinylalkohol-Polymeren mit Ethylenoxid, wobei der Anteil der Ethylenoxid-Einheiten im oxethylierten Vinylalkohol-Polymer 5 bis 75 Gew.-%, insbesondere 10 bis 60 Gew.-%, beträgt. Diese Umsetzungsprodukte von Vinylalkohol-Polymeren können als alleinige Polymer-Komponente in den Mischungen M enthalten sein; sie können aber auch in Mischung mit anderen Vinylalkohol-Polymeren, insbesondere den erwähnten verseiften Polyvinylestern vorliegen, wobei dann der Anteil der Umsetzungsprodukte des Polyvinylalkohols vorteilhaft 30 Gew.-%, bezogen auf die gesamten in der Mischung enthaltenden Vinylalkohol-Polymeren, oder mehr beträgt. Darüber hinaus ist es möglich, daß die genannten Vinylalkohol-Polymeren oder -Copolymeren und/oder deren Derivate mit bis zu etwa 30 Gew.-%, bezogen auf den Polymeranteil des jeweiligen fotopolymerisierbaren und/oder fotovernetzbaren Materials, an verträglichen Melanin-Formaldehyd-Harzen, Harnstoff-Formaldehyd-Harzen oder Phenol-Formaldehyd-Harzen abgemischt sind.

Besonders geeignete Polymerbindemittel M1 sind auch die in wäßrigen oder alkoholischen Lösungsmitteln löslichen oder dispergierbaren linearen synthetischen Polyamide mit wiederkehrenden Amidgruppen in der Molekülhauptkette. Von ihnen werden die Copolyamide bevorzugt, die in üblichen niederen aliphatischen Alkoholen, wie z. B. Ethanol oder n-Propanol, oder Gemischen von diesen Alkoholen mit Wasser löslich sind. Geeignete Polyamid-Bindemittel dieser Art sind z. B. in der FR-A-15 20 856 und der DE-A-22 02 357 beschrieben. Besonders geeignete Copolyamide sind solche, die durch Mischkondensation eines Gemisches aus einem oder mehreren Lactamen, insbesondere Caprolactam und mindestens einem Dicarbonsäure/Diamin-Salz hergestellt worden sind, z. B. aus ε-Caprolactam, Hexamethylendiamonium-Adipat und dem 4,4'-Diaminodicyclohexylmethan/Adipinsäure-Salz. Als weitere Polymerbindemittel seien auch Polyurethane genannt, soweit sie den oben genannten Anforderungen genügen.

Als fotopolymerisierbare, olefinisch ungesättigte Monomere für die Mischung M kommen u. a. die bekannten Monomere mit einem Molekulargewicht unter 2000 in Frage, die für die polymere Bindemittel enthaltende fotopolymerisierbare Materialien an sich bekannt sind, wobei sich natürlich Art und Menge der fotopolymerisierbaren Monomeren nach dem mitverwendeten polymeren Bindemittel richten, mit dem sie verträglich sein sollen. Sehr geeignet sind fotopolymerisierbare niedermolekulare Verbindungen mit 2 oder mehr ethylenisch ungesättigten fotopolymerisierbaren Doppelbindungen allein oder deren Mischungen mit Monomeren mit nur einer olefinisch ungesättigten fotopolymerisierbaren Doppelbindung, wobei der Anteil der Monomeren mit nur einer Doppelbindung von mitverwandten Polymerbindemitteln abhängt, bei Polyamiden im allgemeinen etwa 5 bis 50 Gew.-% und bevorzugt 5 bis 30 Gew.-% der Gesamtmonomerenmenge beträgt, im Fall von Vinylalkohol-Polymeren höher liegt. Es ist unter bestimmten Voraussetzungen selbstverständlich möglich, als fotopolymerisierbare Monomere überwiegend nur solche einzusetzen, die nur eine fotopolymerisierbare Doppelbindung im Molekül enthalten, insbesondere dann, wenn das mitverwandte Polymerbindemittel selber einen hohen Anteil an fotovernetzbaren Doppelbindungen enthält, wie z. B. im Fall der acryloierten und/oder methacryloierten Vinylalkohol-Polymerisate. Im allgemeinen haben die fotopolymerisierbaren Monomeren einen Siedepunkt von über 100° C bei Atmosphärendruck.

Als Beispiele für fotopolymerisierbare olefinisch ungesättigte niedermolekulare Verbindungen seien genannt: Mono-, Di- und Polyacrylate und -methacrylate, wie sie durch Veresterung von Acrylsäure oder Methacrylsäure mit ein- oder mehrwertigen niedermolekularen Alkoholen hergestellt werden können. Hierzu gehören u. a. die Di- und Tri-(meth)acrylate von Ethylenglykol, Diethylenglykol, Triethylenglykol, Polyethylenglykol mit einem Molekulargewicht bis etwa 500, 1,2-Propandiol, 1,3-Propandiol, Polypropylenglykolen mit einem Molekulargewicht bis etwa 500, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole oder Polyole, wie z. B. Ethylenglykol-mono-(meth)-acrylat, 1,2-Propandiol-mono-(meth)acrylat, 1,3-Propandiol-mono-(meth)acrylat und das Di-, Tri- oder Tetraethylenglykol-mono-(meth)acrylat. Weiterhin kommen fotopolymerisierbare, olefinisch ungesättigte niedermolekulare Verbindung in Betracht, die Urethangruppen und/oder Amidgruppen enthalten, wie die aus aliphatischen Diolen der vorstehend genannten Art, organischen Diisocyanaten, wie z. B. Hexamethylendiisocyanat, Toluylendiisocyanat und Isophorondiisocyanat, und Hydroxyalkyl-(meth)acrylaten der oben genannten Art hergestellten niedermolekularen Verbindungen. Genannt seien ferner auch Acrylsäure, Methacrylsäure, (Meth)acrylate von Alkanolen mit 1 bis 6 C-Atomen, Mono- und Bis-(meth)acrylamide von aliphatischen oder aromatischen Diaminen mit 2 bis 8 C-Atomen, wie von Ethylendiamin, Propylendiamin, Butylendiamin, Pentamethylendiamin, Hexamethylendiamin, Octametyhlendiamin oder Xylylendiamin, als auch Derivate der (Meth)acrylamide, z. B. Hydroxymethyl-(meth)acrylamid, oder insbesondere die Umsetzungsprodukte von 2 Mol N-Hydroxymethyl-(meth)-acrylamid mit einem Mol eines aliphatischen Diols, z. B. Ethylenglykol oder Propylenglykol.

Die Auswahl der geeigneten Monomeren richtet sich nach den mitverwendeten Polymerbindemitteln und nach den angestrebten Eigenschaften des Endproduktes und ist dem Fachmann geläufig. Werden als Polymerbindemittel Vinylalkoholpolymerisate eingesetzt, eignen sich als Monomere besonders die wasserlöslichen Monomere, wie z. B. die Hydroxyalkyl-(meth)acrylate, die Mono- oder Di-(meth)-acrylate von Polyethylenglykolen oder Mischungen hiervon mit Di- oder Poly-(meth)acrylaten der oben genannten Art. Wählt man fotopolymerisierbare und/oder fotovernetzbare Materialien mit Polyamiden als Polymerbindemittel, so eignen sich von den genannten Monomerarten neben den Di- und Poly-(meth)acrylaten besonders solche, die zusätzlich zu den Doppelbindungen noch Amid und/oder Urethangruppen enthalten, wie die (Meth)acrylamide sowie insbesondere die Derivate der (Meth)acrylamide.

Die fotopolymerisierbaren bzw. fotovernetzbaren Mischungen M enthalten die Polymeren und die fotopolymerisierbaren olefinisch ungesättigten Monomeren im allgemeinen in einer Menge von etwa 50 bis 90 Gew.-% bzw. von 10 bis 50 Gew.-%, jeweils bezogen auf die Summe von Polymeren und Monomeren. Der Anteil der Monomeren kann in einzelnen Fällen auch größer oder kleiner sein. So ist es beispielsweise möglich, den Anteil der Monomeren unter 10 Gew.-% abzusenken, wenn in den Mischungen M ungesättigte Polymere mit einem hinreichend hohen Gehalt an fotovernetzbaren Doppelbindungen enthalten sind.

Als Fotopolymerisationsinitiatoren, die in den Mischungen M im allgemeinen in Mengen von 0,05 bis 10 Gew.-% und insbesondere von 0,5 bis 5 Gew.-%, bezogen auf die Mischung M, enthalten sind, kommen die bekannten und üblichen Fotopolymerisationsinitiatoren und Systeme für die Auslösung einer Fotopolymerisation bei Bestrahlung mit aktinischem Licht in Frage, wie sie hinreichend in der einschlägigen Fachliteratur beschrieben sind. Genannt seien z. B. Acyloine und deren Derivate, wie Benzoin, Benzoinalkylether, z. B. Benzoinmethylether oder Benzoinisopropylether, ı-Methylolbenzoin und dessen Ether oder ı-Methylbenzoin und dessen Ether; 1,2 Diketone und deren Derivate wie Diacetyl, Benzil, Benzilketale wie Benzildimethylketal, Benzilmethylethylketal, Benzilmethylbenzylketal oder Benzyletylenglykol-monoketal; Acylphosphinoxid-Verbindungen, insbesondere Acyldiarylphosphinoxide und speziell Acyl-diphenylphosphinoxide, deren Acylrest sich von einer tertiären aliphatischen oder cycloaliphatischen Carbonsäure oder von einer mindestens in 2,6-Stellung substituierten Benzoesäure ableitet, wie sie in der DE-A-29 09 992 ausführlich beschrieben sind. Die Fotopolymerisationsinitiatoren können allein oder in Mischung miteinander oder auch in Mischung mit Aktivatoren, wie z. B. tertiären Aminen, eingesetzt werden.

Es ist oft zweckmäßig, den Mischungen M in den Schichten S andere übliche Hilfsstoffe und Zusätze zuzugeben. Hierzu gehören insbesondere die Inhibitoren gegen die thermische Polymerisation, wie Hydrochinon, p-Methoxyphenol, m-Dinitrobenzol, p-Chinon, Methylenblau, β-Naphtol, N-Nitrosamine, wie N-Nitrosodiphenylamin oder die Salze, insbesondere die Alkali- und Aluminiumsalze des N-Nitroso-cyclohexylhydroxylamins. Diese Inhibitoren werden im allgemeinen in Mengen von 0,01 bis 2,0 Gew.-%, bezogen auf das Material der Schicht S, verwendet. Die Materialien können darüber hinaus als weitere Zusätze beispielsweise Weichmacher, Farbstoffe, Pigmente oder dergleichen enthalten.

Im allgemeinen und mit Vorteil enthalten die Schichten S keine Substanzen mit reaktiven Gruppen, wie z. B. Isocyanat-, Amino-, Epoxyoder Anhydrid-Gruppierungen, die beim Trocknen der Schichten, insbesondere beim Trocknen bis zu Temperaturen von etwa 110° C, mit anderen Substanzen der Schicht S chemisch reagieren. So enthält im allgemeinen die Mischung M auch keine fotopolymerisierbaren Monomeren mit chemischen Gruppen, die beim Trocknen bei den genannten Temperaturen z. B. mit dem Polymerbindemittel oder z. B. mit zugesetzten Härtern durch chemische Umsetzung reagieren.

Als dimensionsstabile Träger für die Schicht S kommen bevorzugt Metallbleche wie Stahl- oder Aluminiumbleche, ferner Metallzylinder in Frage. Mit Vorteil werden sie vor dem Aufbringen der Schicht S in an sich bekannter Weise zur Verbesserung der Schichthaftung vorbehandelt bzw. mit einer dünnen Haftschicht versehen.

Das Aufbringen der Schicht S auf die ggf. vorbehandelten Träger erfolgt in bekannter Weise durch Auftragen einer innigen Mischung der Schichtbestandteile z. B. durch Extrudieren, Kalandrieren oder Pressen oder bevorzugt durch Aufgießen und Trocknen einer Lösung der Mischung. Auf die Ausbildung einer glatten Schichtoberfläche ist hierbei Wert zu legen, wobei die Oberfläche auch aus einer dünnen, etwa 1 bis 5 μm dicken Sauerstoffsperrschicht eines Polymeren bestehen kann, die haftfest mit dem unteren Teil der Schicht verbunden, UV-durchlässig und beim Entwickeln des Reliefs mit den anderen unbelichteten Bestandteilen der Schicht S entfernbar ist, z. B. auswaschbar ist.

Von der Auswahl der Bestandteile der Schicht S wird der Anwendungsbereich der Tiefdruckformen insoweit mitbestimmt, als die Druckschicht gegenüber den für die Druckfarben verwendeten Lösungsmitteln resistent sein muß. Die am meisten verwendeten Lösungsmittel in Tiefdruckfarben sind Toluol und in geringerem Maße auch Benzin, d. h. niedrig siedende aliphatische Kohlenwasserstoffe. Daneben kommen jedoch auch alkohol-, ester-, keton- oder wasserhaltige Tiefdruckfarben zum Einsatz. Da die fotopolymeren Druckschichten nicht gegen alle Lösungsmittel gleichermaßen resistent sind, hängt die Wahl des Basispolymeren für die Schicht S auch von dem beim Tiefdruck zur Anwendung kommenden Druckfarbenlösungsmittel ab. Für die am meisten verbreitetsten Druckfarben auf Basis von Toluol oder Benzin als Lösungsmittel haben sich für die Herstellung der Tiefdruckformen insbesondere solche Mischungen M bewährt, die in der Schicht S als Basis-Polymer ein Polyamid oder Mischpolyamid bzw. ein Vinylalkoholpolymerisat oder teilverseiftes Vinylester-Polymerisat enthalten.

Zur Herstellung der Tiefdruckformen werden die erfindungsgemäßen lichtempfindlichen Aufzeichnungsmaterialien durch eine geeignete Bildvorlage mit aktinischem Licht bestrahlt, wodurch die belichteten Bereiche der Schicht S vernetzen und fest werden und so z. B. in einer Entwicklerflüssigkeit unlöslich werden, während die unbelichteten Bereiche löslich bleiben und mit der Entwicklerflüssigkeit ausgewaschen werden können.

Zum Belichten der lichtempfindlichen Aufzeichnungsmaterialien werden Lichtquellen eingesetzt, die aktinisches Licht im Wellenlängenbereich von im allgemeinen 250 bis 500 nm, vorzugsweise im Bereich von 300 bis 450 nm auszustrahlen vermögen und deren Emissionsmaxima im allgemeinen im Bereich der Absorption der Fotoinitiatoren liegen. Für die erfindungsgemäße Herstellung der Tiefdruckformen können die in der Reproduktionstechnik üblichen Lichtquellen, wie Kohlebogenlampen, aktinische oder superaktinische Leuchtstoffröhren, Quecksilber-Nieder-, -Mittel und -Hochdruckstrahler, die gegebenenfalls dotiert sein können, sowie Xenonlampen oder Laser mit hohem UV-Anteil, z. B. Argon-Ionen-Laser mit UV-Ausgangsleistungen von 1 bis 2 Watt, verwendet werden. Der Belichtungsvorgang kann dabei in üblichen und gebräuchlichen Kontaktkopierrahmen (bei Platten oder Folien) oder auf handelsüblichen Rundbelichtungsgeräten (bei Zylindern) durchgeführt werden. Als Bildvorlage für die Belichtung können die üblichen Raster- oder Strich-Positive verwendet werden oder auch Halbton-Positive in Kombination mit Führungsraster-Vorlagen. Die genaue Belichtungszeit hängt von der Art des für die Mischung M der Schicht S verwendeten Materials ab. Sie liegt üblicherweise im Bereich von 0,5 bis 10 Minuten und läßt sich für das verwendete Schichtmaterial durch wenige Vorversuche leicht ermitteln.

Das Entfernen der unbelichteten Anteile der Schicht S bzw. Entwickeln der Schicht S unter Ausbildung einer Reliefschicht S mit der Raster-und Näpfchenstruktur kann in an sich bekannter Weise erfolgen, z. B. durch Ausblasen oder Ausbürsten unbelichteter flüssiger oder viskoser Schichtbestandteile oder — bevorzugt — durch Behandeln der Schicht mit einem Entwicklerlösungsmittel unter Auswaschen der unbelichteten und unvernetzten, löslichen Schichtbestandteile. Beispiele geeigneter Entwicklerlösungsmittel sind niedere aliphatische Alkohole, Gemische von Alkoholen mit Wasser, Glykolether, Glykolester, wäßrige oder alkoholische Alkalilauge, verdünnte wäßrige Säure oder auch Wasser selber. Für Schichten S auf Basis von Vinylalkoholpolymerisaten sind beispielsweise Wasser oder wäßrig-alkalische Lösungen als Entwicklerlösungsmittel geeignet; bei Schichten S auf Basis von Copolyamiden haben sich als Entwicklerlösungsmittel niedere aliphatische Alkohole, insbesondere Gemische von solchen Alkoholen mit Wasser, beispielsweise Mischungen aus Ethanol mit Wasser im Verhältnis 8 : 2 bewährt.

Auch wenn als Entwicklerlösungsmittel bevorzugt solche Lösungsmittel oder Lösungsmittelgemische gewählt werden, die die belichteten, unlöslichen Schichtteile möglichst wenig oder gar nicht angreifen, diffundieren im allgemeinen die Entwicklerlösungsmittel auch in die unlöslichen Schichtteile der belichteten Schicht S ein, so daß es ratsam ist, diese Lösungsmittelreste durch einen kurzzeitigen Trocknungsprozeß anschließend an den Auswaschvorgang zu entfernen. Die Trocknung der Reliefschicht S kann zuerst bei Raumtemperatur, soll aber auch in jedem Fall im Bereich von 60°C bis 130°C, bevorzugt bei 80 bis 120°C und insbesondere bei etwa 80°C erfolgen und wird durch einen wirksamen Luftwechsel, z. B. durch ein Gebläse, einen Ventilator oder ähnliches, gefördert. Die erforderliche Zeit zur Trocknung, d. h. zur Entfernung aller Lösungsmittelreste, hängt vor allem von der Schichtdicke und der angewandten Trockentemperatur ab. Sie kann z. B. bei 50 µm dicken Schichten nur ca. 10 bis 15 Min., bei 300 µm dicken Schichten Stunden betragen. Oft ist es auch zweckmäßig, das Trocknen dickerer Schichten stufenweise durchzuführen. So ließen sich 200 µm dicke Schichten z. B. günstig 1 Std. bei 80°C und dann 2 Std. bei 120°C trocknen.

In manchen Fällen ist es von Vorteil, die Reliefschicht S nach dem Entfernen der unbelichteten Anteile der Schicht S und ggf. nach dem vorstehend beschriebenen Trocknen vollflächig nachzubelichten, um die Vernetzung in der Reliefschicht S zu vervollständigen, was bei Anwesenheit stark lichtabsorbierender Substanzen in der Schicht S empfehlenswert ist. In vielen Fällen ist eine Trocknung der Schicht bei gleichzeitiger Nachbelichtung vorteilhaft.

Besonderes Kennzeichen der erfindungsgemäßen Herstellung von Tiefdruckformen ist, daß die entwickelten und ggf. nachbelichteten Reliefschichten S zur Erzielung einer harten, nichtspröden Tiefdruckform durch kurzzeitiges Erwärmen auf Temperaturen von 200 bis 260°C und insbesondere 220 bis 240°C einer Nachhärtung unterworfen werden, wobei die Gesamthöhe (maximale Schichtdicke) der reliefbildenden Schicht S um 10 bis 50% und insbesondere 15 bis 30%, bezogen auf die Schichtdicke der Reliefschicht S vor dem Einbrennen, schrumpft. Im allgemeinen sind hierfür Zeiten von 5 bis 60 und insbesondere 20 bis 30 Min. hinreichend, doch sind auch längere Zeiten für das Einbrennen möglich. Eine Verfärbung der eingebrannten Schicht nach hell- bis dunkelbraunen Farbtönen ist für die mechanischen und drucktechnischen Eigenschaften der resultierenden Tiefdruckformen nicht schädlich. Besonderes Kennzeichen dieses Verfahrensschrittes ist, daß die Härte der Oberfläche der eingebrannten Reliefschicht S durch den Einbrennschritt deutlich gesteigert wird und danach eine unter Last gemessene Vickers-Härte von mindestens 50 N/mm$^2$, bevorzugt mindestens 100 N/mm$^2$ aufweist. Reliefschichten mit Copolyamiden als Polymerbindemittel zeigten z. B. einen Anstieg der Vickers-Härte von etwa 15 N/mm$^2$ auf etwa 190 N/mm$^2$, solche mit Polyvinylalkohol als Polymerbindemittel z. B. einen Anstieg der Vickers-Härte von etwa 15 bis 30 N/mm$^2$ auf etwa 190 bis 220 N/mm$^2$, also einen überraschenden Härteanstieg um den Faktor 10 bis 20 bei gleichzeitiger Schrumpfung der Reliefschichtdicke S um 15 bis 30%, ohne gleichzeitig spröde zu werden. Die resultierenden Reliefschichten blieben vielmehr noch biegsam.

Obwohl einerseits zu befürchten war, daß die Materialien beim Einbrennen sich z. T. zersetzen und dabei ihre mechanischen Eigenschaften verlieren, andererseits eine starke Beeinträchtigung der Reliefstruktur der Tiefdruckform beim Einbrennen und Schrumpfen erwartet werden mußte, war beides nicht der Fall. Trotz der Schrumpfung der Gesamtdicke der Schicht S bleibt das Reliefbild erhalten. Näpfchen von z. B. 45 µm Tiefe bei einer Gesamtschichtdicke von 200 µm bleiben etwa in ihrer ganzen Tiefe erhalten und weisen scharfe Ränder auf. Die resultierenden Tiefdruckformen weisen nicht nur eine hohe Härte auf, sie sind auch sehr abriebfest und erlauben den Druck hoher Auflagen bei minimalem Abrieb (weniger als 1 µm). Oberflächenkratzer können wegpoliert werden, Stahlrakel können benutzt werden, ohne daß das Druckbild beeinflussende Beschädigungen der Oberfläche der Tiefdruckform eintreten. Die eingebrannten Tiefdruckformen weisen ferner eine verbesserte Resistenz gegen Druckfarben auf, auch gegenüber alkoholischen Druckfarben. Ein besonderer Vorteil der erfindungsgemäß hergestellten Tiefdruckformen ist, daß sie bei einfacher und preisgünstiger Herstellung mit konventionellen Tiefdruckmaschinen verarbeitbar sind. Sie geben auch bei hoher Auflagenhöhe (500 000 bis 1 000 000) gute Druckqualitäten, auch hinsichtlich der Halbtonwiedergabe.

Die nachstehenden Beispiele und Vergleichsversuche erläutern die Erfindung. Die in den Beispielen und Vergleichsversuchen angegebenen Teile beziehen sich, sofern nicht anders angegeben, auf das Gewicht. Die Methode zur Ermittlung der unter Last gemessenen Vickers-Härte ist beschrieben in der Zeitschrift »Kunststoffe«, Band 60 (1970), Seiten 265 bis 273. Es handelt sich hierbei um eine Anpassung der in DIN 50 133 festgelegten Härteprüfung nach Vickers für die Härtebestimmung von Kunststoffen. Die Dicke der Reliefschicht wurde mit einer Mikrometerschraube gemessen, die Messung der Tiefe von Näpfchen erfolgte mit dem Ätztiefenmikroskop.

### Vergleichsversuch A

Auf ein mit einer Haftschicht aus Polyurethan versehenes, 240 µm starkes Stahlblech wird eine 200 µm starke Schicht S einer innigen Mischung von 68 Teilen eines in wäßrigem Alkohol löslichen Copolyamids aus etwa gleichen Teilen Hexamethylendiamin-adipat, 4,4-Diamino-dicyclohexylmethan-adipat und -Caprolactam, 30 Teilen des Diethers aus 1 Mol Ethylenglykol und 2 Mole N-Methylol-acrylamid und 2 Teilen Benzildimethylketal aufgebracht.

Die fotovernetzbare Schicht S wird durch eine autotypische Tiefdruckvorlage belichtet. Die unbelichteten, noch löslichen Anteile der Schicht S werden mit einem Ethanol/Wasser-Gemisch ausgewaschen und die resultierende Reliefform wird bei 80° C 30 Min. getrocknet.

Mit der Tiefdruckform wird mit einer handelsüblichen Tiefdruckmaschine ein Drucktest durchgeführt. Nach 4000 Zylinderumdrehungen sind im Druckbild Streifen zu sehen und nach 40 000 Zylinderumdrehungen kann eine deutliche Abnahme der Tondichte aufgrund des verringerten Näpfchenvolumens festgestellt werden. Die unter Last gemessene Vickers-Härte der Druckform beträgt 15 N/mm$^2$.

### Vergleichsversuch B

Eine gemäß Vergleichsversuch A hergestellte Tiefdruckform wird in einem Abriebtester des Typs AT II der Firma Burda, Offenburg, geprüft. Nach etwa 50 000 Rakeldurchgängen zeigte die Tiefdruckform tiefe Kratzer und eine Abnahme der Näpfchen-Volumen wie im Vergleichsversuch A. Die Rakel wurde stark beschädigt.

### Vergleichsversuch C

Auf ein mit einer Polyurethan-Haftschicht versehenes, 240 µm starkes Stahlblech wird eine 200 µm starke Schicht S einer innigen Mischung von 60 Teilen eines teilverseiften Polyvinylacetats (Verseifungsgrad 82 Mol.%, Polymerisationsgrad 500), 38 Teilen 2-Hydroxyethylmethacrylat und 2 Teilen Benzildimethylketal aufgetragen.

Die fotovernetzbare Schicht wird durch eine autotypische Tiefdruckvorlage belichtet. Die unbelichteten, noch löslichen Anteile der Schicht S werden mit Wasser ausgewaschen und die resultierenden Reliefformen wird 30 Min. bei 80° C getrocknet.

Die Tiefdruckform wird in einem Abriebtester des Typs AT II der Firma Burda, Offenburg, geprüft. Nach etwa 50 000 Rakeldurchgängen ist die Druckform ähnlich beschädigt wie die im Vergleichsversuch B getestete. Die Rakel ist ungleichmäßig abgenutzt. Die unter Last gemessene Vickers-Härte beträgt 30 N/mm².

### Beispiel 1

Es wird eine Tiefdruckform wie in Vergleichsversuch A angegeben hergestellt. Die Tiefdruckform wird zusätzlich 15 Min. bei 120°C unter gleichzeitiger UV-Vollbelichtung getrocknet. Nach der Trocknung hat die Tiefdruckform eine Dicke der Reliefschicht S von 190 µm und Näpchentiefen von 43 µm. Die getrocknete Reliefform wird danach 30 Min. bei 240°C eingebrannt und hat dann eine Dicke der Reliefschicht S von 150 µm (ca. 21% Schrumpf) und Näpfchentiefen von 48 µm. Die resultierende Tiefdruckform hat eine unter Last gemessene Vickers-Härte von 190 N/mm². Die Tiefdruckform wird in einem Abriebtester AT II der Firma Burda, Offenburg, geprüft. Nach 1 Million Rakeldurchgängen sind keine das Druckbild beeinflussenden Beschädigungen der Druckform feststellbar.

### Beispiel 2

Es wird eine Tiefdruckform wie in Vergleichsversuch C angegeben hergestellt. Die Tiefdruckform wird dann 15 Min. bei 120°C unter gleichzeitiger UV-Vollbelichtung getrocknet und danach 30 Min. bei 240°C unter Luft eingebrannt, wobei die Dicke der Reliefschicht S sich von 215 µm auf 180 µm (16,3% Schrumpf) verringert, die Näpfchentiefen aber von 35 µm auf 41 µm ansteigen. Die resultierende Tiefdruckform hat eine unter Last gemessene Vickers-Härte von 220 N/mm². Bei der Prüfung im Abriebtester AT II der Firma Burda, Offenburg, sind nach 500 000 Rakeldurchgängen keine das Druckbild beeinflussenden Beschädigungen der Druckform feststellbar.

## Patentansprüche

1. Verfahren zur Herstellung von Fotopolymer-Tiefdruckformen durch

a) bildmäßiges Belichten mit aktinischem Licht von einer auf einem dimensionsstabilen Träger aufgebrachten, etwa 30 bis 600 µm starken Schicht S mit einer einen Fotoinitiator enthaltenden Mischung M von

M1) mindestens einem in einem wäßrigen oder alkoholischen Lösungsmittel löslichen oder dispergierbaren Polymerbindemittel und

M2) mindestens einem damit verträglichen fotopolymerisierbaren olefinisch ungesättigten Monomeren,

b) Entfernen der unbelichteten Anteile der Schicht S,
c) ggf. Nachbelichten sowie
d) Trocknen der resultierenden Reliefschicht, ggf. unter Integration des Nachbelichtens,

dadurch gekennzeichnet, daß man die entwickelte und ggf. nachbelichtete Reliefschicht bei 60 bis 130°C trocknet und danach zur Erzielung einer harten, nichtspröden Tiefdruckform die Reliefschicht S durch Einbrennen bei 200 bis 260°C um 10 bis 50% der Schichtdicke, bezogen auf die Schichtdicke vor dem Einbrennen, schrumpft.

2. Verfahren nach Anspruch 1, dadurch gekennzeichnet, daß die Mischung M als Polymerbindemittel M1) ein alkoholisches Copolyamid enthält.

3. Verfahren nach Anspruch1, dadurch gekennzeichnet, daß die Mischung M als Polymerbindemittel M1) einen wasserlöslichen Polyvinylalkohol enthält.

4. Verfahren nach einem der Ansprüche 1 bis 3, dadurch gekennzeichnet, daß das Einbrennen bei 220 bis 240°C erfolgt.

5. Verfahren nach einem der Ansprüche 1 bis 4, dadurch gekennzeichnet, daß man die Reliefschicht S um 15 bis 30% ihrer Schichtdicke schrumpft.

6. Verfahren nach einem der Ansprüche 1 bis 5, dadurch gekennzeichnet, daß die Mischung M als fotopolymerisierbare olefinisch ungesättigte Monomere Acrylsäure und/oder Methacrylsäureester enthält.

7. Verfahren nach einem der Ansprüche 1 bis 6, dadurch gekennzeichnet, daß die Mischung M als fotopolymerisierbare olefinisch ungesättigte Monomere Ether aus N-Methylolacrylamid oder -methacrylamid und mindestens zweiwertigen Alkoholen enthält.

8. Verfahren nach einem der Ansprüche 1 bis 7, dadurch gekennzeichnet, daß die fotopolymerisierbaren Monomeren der Mischung M keine reaktiven Gruppen enthalten, die beim Vortrocknen mit dem Polymerbindemittel oder ggf. zugesetzten Härtern chemisch reagieren.

9. Verfahren nach einem der Ansprüche 1 bis 8, dadurch gekennzeichnet, daß die Schicht S keine Substanzen mit reaktiven Gruppen enthält, die beim Vortrocknen mit anderen Substanzen der Schicht S chemisch reagieren.

## Claims

1. A process for the production of a photopolymer gravure printing plate by

a) exposing imagewise to actinic light a layer L which is applied to a dimensionally stable base, is about 30—600 µm thick, and comprises a photoinitiatorcontaining mixture M of

M1) one or more polymeric binders which are soluble or dispersible in an aqueous or alcoholic solvent, and

M2) one or more olefinically unsatured, photopolymerizable monomers which are compatible with the binder(s),

b) removing the unexposed areas of the layer L,

c) optionally effecting after-exposure, and

d) drying the resulting relief layer, with or without simultaneous after-exposure,

wherein the developed and optionally after-exposed relief layer is dried at 60 to 130°C, and the relief layer L is subsequently baked at from 200 to 260°C, thereby reducing its thickness by 10-50%, based on the thickness before baking, to give a hard, non-brittle gravure printing plate.

2. A process as claimed in claim 1, wherein the mixture M contains an alkohol-soluble nylon copolymer as the polymeric binder M1).

3. A process as claimed in claim 1, wherein the mixture M contains a water-soluble polyvinyl alcohol as the polymeric binder M1).

4. A process as claimed in any of claims 1 to 3, wherein baking is carried out at from 220 to 240°C.

5. A process as claimed in any of claims 1 to 4, wherein the thickness of the relief layer L is reduced by 15—30%.

6. A process as claimed in any of claims 1 to 5, wherein the mixture M contains, as olefinically unsaturated, photopolymerizable monomers, acrylates and/or methacrylates.

7. A process as claimed in any of claims 1 to 6, wherein the mixture M contains, as olefinically unsaturated, photopolymerizable monomers, ethers obtained from N-methylolacrylamide or N-methylolmethacrylamide and at least dihydric alcohols.

8. A process as claimed in any of claims 1 to 7, wherein the photopolymerizable monomers in the mixture M do not contain any reactive groups which react chemically with the polymeric binder, or with any added hardeners, during predrying.

9. A process as claimed in any of claims 1 to 8, wherein the layer L does not contain any substance which possesses reactive groups which react chemically, during predrying, with other substances in the layer L.

## Revendications

1. Procédé de préparation de formes d'héliogravure photopolymères, par

a) exposition, selon une image, à la lumière actinique, d'une couche S d'épaisseur d'environ 30 à 600 µm, appliquée sur un support stable en dimensions, avec un mélange M, contenant un photoinitiateur, de

M1) au moins un liant polymère soluble ou dispersable dans un solvant aqueux ou alcoolique et

M2) au moins un monomère, à insaturation oléfinique, photopolymérisable, compatible avec M1,

b) élimination des parties non exposées de la couche S,

c) éventuellement post-exposition, ainsi que

d) séchage de la couche en relief résultante, éventuellement avec intégration de la post-exposition,

caractérisé par le fait que l'on sèche, entre 60 et 130°C, la couche en relief, développée et éventuellement postexposée, puis, pour obtenir une forme d'héliogravure dure, non cassante, on rétrécit la couche en relief S, par cuisson entre 200 et 260°C, de 10 à 50% de son épaisseur, rapporté à l'épaisseur de la couche avant sa cuisson.

2. Procédé selon la revendication 1, caractérisé par le fait que le mélange M contient, comme liant polymère M1, un copolyamide alcoolique.

3. Procédé selon la revendication 1, caractérisé par le fait que le mélange M contient, comme liant polymère M1, un polyalcoolvinylique soluble dans l'eau.

4. Procédé selon l'une des revendications 1 à 3, caractérisé par le fait que la cuisson est effectuée entre 220 et 240°C.

5. Procédé selon l'une des revendications 1 à 4, caractérisé par le fait que l'on rétrécit la couche en relief S de 15 à 30% de son épaisseur.

6. Procédé selon l'une des revendications 1 à 5, caractérisé par le fait que le mélange M contient, comme monomère, à insaturation oléfinique, photopolymérisable, de l'ester acrylique et/ou méthacrylique.

7. Procédé selon l'une des revendications 1 à 6, caractérisé par le fait que le fait que le mélange M contient, comme monomère, à insaturation oléfinique, photopolymérisable, de l'éther de N-méthylolacrylamide ou -méthacrylamide et d'alcools au moins bivalents.

8. Procédé selon l'une des revendications 1 à 7, caractérisé par le fait que les monomères photopolymérisables du mélange M ne contiennent pas de groupes réactifs qui, lors du préséchage, réagissent chimiquement avec le liant polymère ou des durcisseurs éventuellement ajoutés.

9. Procédé selon l'une des revendications 1 à 8, caractérisé par le fait que la couche S ne contient pas de substances à groupes réactifs qui, lors du préséchage, réagissent chimiquement avec d'autres substances de la couche S.